# EUROPEAN PATENT SPECIFICATION

(11) **EP 3 374 782 B1**
(45) Date of publication and mention of the grant of the patent: **26.05.2021**
(21) Application number: 16788773.6
(22) Date of filing: 28.10.2016
(51) Int. Cl.: G01R 33/44, G01N 24/08, G01R 33/34

(54) **EXPLOSIVES DETECTION SYSTEM USING NUCLEAR QUADRUPOLE RESONANCE SENSORS**
SPRENGKÖRPERNACHWEISSYSTEM UNTER VERWENDUNG VON KERNQUADRUPOLRESONANZSENSOREN
SYSTÈME DE DÉTECTION D'EXPLOSIFS AU MOYEN DE DÉTECTEURS À RÉSONANCE QUADRIPOLAIRE NUCLÉAIRE

(30) Priority: 10.11.2015 GB 201519818
(43) Date of publication of application: 19.09.2018
(73) Proprietor: Kings College London, London, Greater London WC2R 2LS (GB)
(72) Inventor: BARRAS, Jamie, Strand London WC2R 2LS (GB); ALTHOEFER, Kaspar, Strand London WC2R 2LS (GB)
(74) Representative: Wallin, Nicholas James
(86) International application number: PCT/GB2016/053354
(87) International publication number: WO 2017/081441

(56) References cited:
- EP-B1- 0 838 036
- US-A- 4 932 411
- US-A1- 2002 045 816
- US-A1- 2010 168 555
- US-A1- 2011 257 511
- US-B2- 8 917 092
- MILLER J.B.: "Nuclear Quadrupole Resonance Detection of Explosives: An Overview", PROCEEDINGS OF SPIE - THE INTERNATIONAL SOCIETY FOR OPTICAL ENGINEERING - DETECTION AND SENSING OF MINES, EXPLOSIVE OBJECTS, AND OBSCURED TARGETS XVI, vol. 8017, 2011, pages 801715-1-801715-7, XP040560475, USA
- GASSER R ET AL: "Prodding to detect mines: a technique with a future", PROCEEDINGS OF THE 1998 2ND INTERNATIONAL CONFERENCE ON THE DETECTION OF ABANDONED LAND MINES, IEE CONFERENCE PUBLICATION, 12 October 1998 (1998-10-12), pages 168-172, XP006505029, ISBN: 978-0-85296-711-9
- CIANCHETTI MATTEO ET AL: "STIFF-FLOP surgical manipulator: Mechanical design and experimental characterization of the single module", 2013 IEEE/RSJ INTERNATIONAL CONFERENCE ON INTELLIGENT ROBOTS AND SYSTEMS, IEEE, 3 November 2013 (2013-11-03), pages 3576-3581, XP032537647, ISSN: 2153-0858, DOI: 10.1109/IROS.2013.6696866 [retrieved on 2013-12-27]
- SALVATORE BAGLIO ET AL: "Intelligent Prodder: Implementation of Measurement Methodologies for Material Recognition and Classification With Humanitarian Demining Applications", IEEE TRANSACTIONS ON INSTRUMENTATION AND MEASUREMENT., vol. 64, no. 8, 1 August 2015 (2015-08-01) , pages 2217-2226, XP055337911, US ISSN: 0018-9456, DOI: 10.1109/TIM.2014.2386917

## Description

### Technical Field

Embodiments of the present invention relate to a detector coil arrangement for man-portable NQR detection systems, and in particular to a detector coil arrangement arranged on a carrier to allow the coil to be passed through a physical medium.

### Background to the Invention and Prior Art

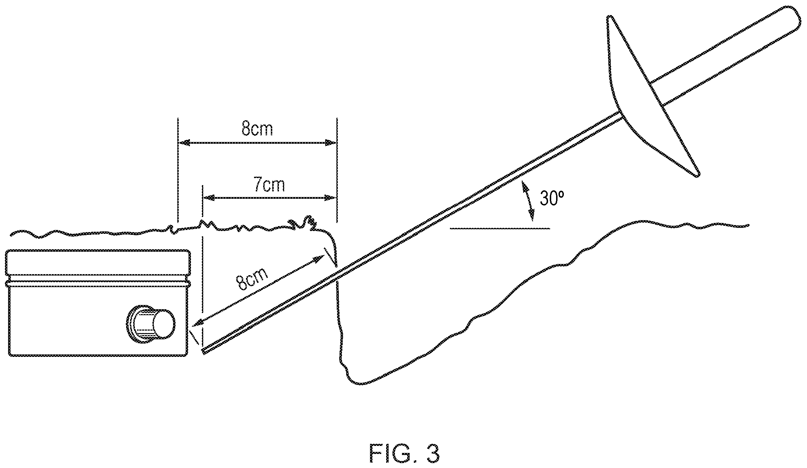

There are 110 million active landmines in place in the world; 10 people a day are killed by landmine blasts, over 1 million have been killed or maimed since 1975 (*cf* www.findabetterway.org). There is a pressing need for new technologies to speed up the removal of landmines from the ground. Currently, having identified a mine-like object using metal detection or ground penetrating radar, the conventional approach for determining if this mine-like object is a mine is called "prodding and excavation" - sticking a metal stick in the ground to feel for the object then digging it up. Figure 3 illustrates a typical "mine-prodder" stick, and its usage. This is time-intensive, and requires a lot of training to get right. In recent years researchers have begun to investigate adding sensors to the prodder to give additional feedback to the de-miner (the person doing the prodding) - creating "intelligent prodders"; approaches have focused mainly on force reading (how hard is the object, how much resistance to poking does it have) with piezoelectric sensors or using ultrasound to get a sense of the objects physical make-up (references attached), but there has also been investigation by at least one group of using laser-induced breakdown spectroscopy (LIBS) combined with the prodder to detect explosive residue on the outside of the object being probed (http://www.lac.tu-clausthal.de/en/workgroups/angewandte-photonik-lac/projects/laser-assisted-mine-prodder/).

Example prior art documents illustrating the above approaches included US6109112, which relates to an acoustic landmine prodding instrument with force feedback, and US 6386036, which also relates to a force feedback prodded. Another prodder design which makes use of piezoelectric material to measure force feedback was described by Baglio et al. The development of an intelligent manual prodder for material recognition, available before the priority date from http://www.fp7-tiramisu.eu/sites/fp7-tiramisu.eu/files/publications/IARP-8-BAGLIO.pdf. Finally, Baglio *et al.* also published a review paper which gives background on the present state of the art in prodding techniques, at http://www.fp7-tiramisu.eu/sites/fp7-tiramisu.eu/files/publications/IARP%2010%20-%20S.Baglio.pdf.

The limitations of the force feedback and ultrasonic approaches is that they are still only registering the fact that the object is physically like a mine; the LIBS approach does at least look for explosive, but as this is at a trace level, it can be confused by ground contamination, particular if there is water flow (i.e. the trace has been transferred to the object being examined from a mine somewhere else in the locality).

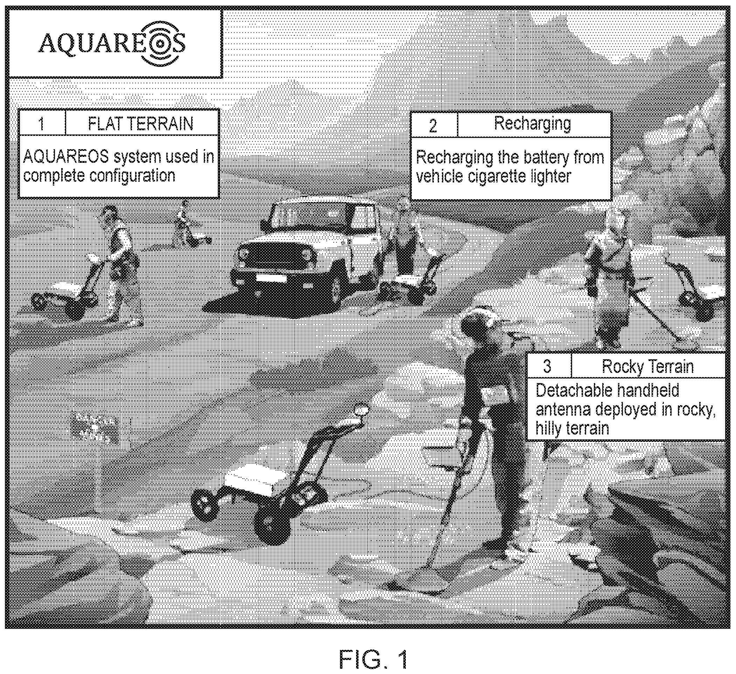

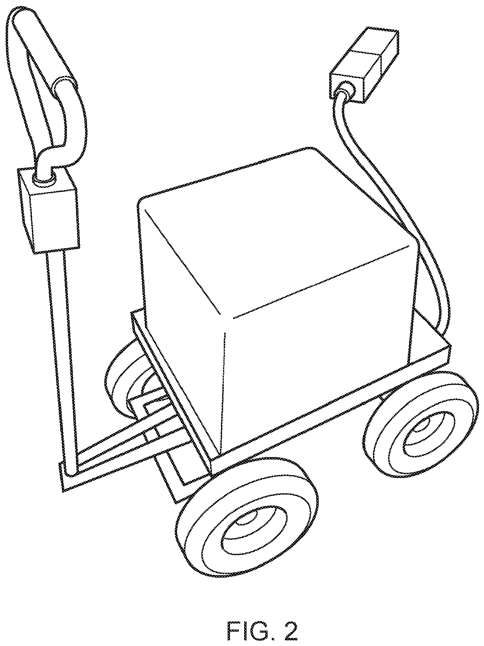

As a precursor to prodding, wide area mine detection is used in peacetime mine clearance operations to try and locate the vicinity of a mine, with prodding then being used to fix the location. Mine detection can be undertaken using NQR systems, mounted on trolleys, which can be wheeled over an area to be cleared. The AQUAREOS initiative undertaken by King's College London in combination with the mine clearance charity Find A Better Way aims to use trolley mounted NQR systems to speed up the process of mine detection and clearance. The primary elements of such a system are shown in Figure 1, and a photograph of a trolley mounted NQR system is shown in Figure 2.

Nuclear Quadrupole Resonance (NQR), often referred to just as Quadrupole Resonance (QR), is a known RF detection modality for the remote direction of explosives materials. It is commercially employed already in airports and other public locations for explosives detection. The great advantage of QR is that it directly detects the chemical signature of the explosive content of the mine. As a radiofrequency technique, QR lends itself to remote sensing. However, as a near-field method (frequencies for nitrogen QR range from 0 - 5.5 MHz) there is considerable signal attenuation with increasing separation between the sensor and the target (i.e. the deeper the mine, the weaker the returned signal). There is equally, a great deal of RF power attenuation for the same reason, meaning that considerable RF power is needed to "reach" buried mines. In combination with the already-weak QR response, these factors represent a considerable challenge for the implementation of QR as a remote sensor for confirming that a target is a buried mine. Essentially, in order to overcome these limitations high power signals must be transmitted, and/or large, high gain, transmit and detector coils used in order to detect the weak QR response. In the context of peaceful (i.e. non-military) mine clearance, it is these technical limitations that dictate the use of large, powerful, trolley mounted systems, such as those described above. Truly man-portable QR detection systems have, so far, not been possible because of the power requirements and size requirements of the transmit and detect coils.

### Prior Art

Other example prior art includes a first class of documents that relate to NMR imaging, a second class of documents that relate to NQR explosives detection, and a third class of documents relating to mine prodders. The first class of documents include arrangements where a coil used for NMR imaging purposes is provided on the end of an elongate carrier, and example such prior art includes US4932411, US2011/0257511, US 2002/0045816, and US2010/168555. The second class of documents relate to known NQR explosive detection systems more generally, and include US 8917092 (Rudakov), Miller "Nuclear Quadrupole Resonance Detection of Explosives - An Overview", Proc. SPIE Vol. 8017, and EP 0838036 (BTG). The third class of documents includes the Baglio paper "Intelligent Prodder: Implementation of Measurement Methodologies for Material Recognition and Classification With Humanitarian Demining Applications", referenced *ibid.* as well as 2013 IEEE International Conference on intelligent robots and systems "Stiff-Flop Surgical Manipulator: mechanical design and experimental characterization of the single module", by Cianchetti et al.

### Summary of the Invention

Embodiments of the invention address the above issues by providing an arrangement where an RF transducer such as a small detection coil of an NQR system is mounted on the end of a carrier such as a prodder stick, and is then carried by the carrier into the very near vicinity of, and more particularly for example into contact with, a possible target explosive device. Because the detection coil is brought into contact with or into the very near vicinity of the target, the transmitted NQR signals, and the resultant QR response, can be much lower power, to the extent that such a system can be made fully man-portable, and also be much lower cost to manufacture. As a consequence, NQR explosive detections systems may be deployed in larger numbers than has heretofore been possible, thus increasing the certainty of, and hence safety, of landmine detection, and improving clearance rates.

In view of the above, from a first aspect there is provided an explosives detection system, comprising: a nuclear quadrupole resonance (NQR) detector system having an NQR antenna; and a mine prodder, the arrangement being such that the NQR antenna is carried at or near a distal end of the mine prodder, the arrangement of the NQR antenna and mine prodder being such that in use the mine prodder is able to carry the NQR antenna so that the NQR antenna and mine prodder are able to penetrate through a soil-like medium when in use so as to be brought into contact with a buried object in an orientation such that the NQR antenna is brought into contact with or into the near vicinity of the buried object.

In some embodiments the NQR antenna is a coil antenna. This provides advantages in being able to wrap the coil antenna around the end of the mine prodder.

In the above arrangement the mine prodder is able to carry the coil so that coil and carrier are able in use to penetrate through a solid-type medium when in use. As such, the prodder is able to move the coil through a medium such as soil for landmine detection, or through other materials, such as clothes in a suitcase, for security applications in other areas. The prodder is therefore of elongated shape having a cross-sectional diameter much less than its length, to allow penetration of the carrier into and through a solid-type medium, or to allow penetration through openings of restricted size.

The prodder may be substantially rigid along at least a greater part, or all, of its length. Alternatively, the prodder may have one or more portions along its length of reduced rigidity to allow the prodder to be bent into a desired shape. In addition, the elongate prodder may have one or more portions along its length of adaptable rigidity, to allow the prodder to be bent into a desired shape. For example, the prodder may be such that it is formed or configured such that the stiffness of the prodder can be varied with respect to time, preferably at any point along its length. This allows one or more portions of the prodder to be rendered less stiff when they are desired to be bent into shape, and then rendered stiffer when they are desired to be kept in a particular position or configuration

As noted, the arrangement is for use with a nuclear quadrupole resonance (NQR) detector system, wherein the sensor coil is connected to the NQR detector system for use as an NQR detector coil. As is known in the art NQR systems are particularly suitable for explosives detection, and hence embodiments of the present invention can be particularly used for such, and in particular for landmine clearance operations.

In one embodiment the coil diameter is in the range of 5mm to 25mm, and more preferably 10 to 20mm. Similarly, the prodder may be of similar or slightly reduced dimensions, in term of its diameter, so that the coil can be wound there-around. In addition the coil length may be in the range of 5mm to 30mm, and more preferably in the range of 9mm to 25mm.

Similarly, when in use as part of an NQR system, the sensor coil generates a RF field strength in the range of 100 microTesla to 1 milliTesla, and/or operates at a peak power of 100mW to 100W.

From another aspect there is also provided a method of target material discrimination, comprising: providing a system according to the above aspect; inserting the mine prodder carrying the NQR antenna at its tip into the ground towards a target so as to bring the NQR antenna into contact with or the near vicinity of the target; and activating the NQR detection system to undertake NQR based target material discrimination

Further features and advantages will be apparent from the appended claims.

### Brief description of the drawings

Embodiments of the invention will now be described with reference to the accompanying drawings, wherein like reference numerals refer to like parts, and wherein: -
Figure 1 is a drawing of a trolley based QR landmine detection system of the prior art;
Figure 2 is a photograph of one of the trolleys shown in Figure 1;
Figure 3 is a diagram of a prior art mine prodder;
Figure 4 is a diagram of a first embodiment of the invention;
Figures 5 (a) to (d) are diagrams of alternative arrangements of coil that may be used in embodiments of the invention;
Figure 6 is a photograph of a prototype embodiment of the invention; and
Figures 7 to 11 are various graphs illustrating the advantaged obtained by embodiments of the invention.

### Overview of Embodiments

Embodiments of the present invention aim to provide an NQR detector system for explosives detection provided with a small detector coil that is placed in use into close proximity or against a target object to be tested. Because the detector coil is placed so close to the target, then the transmit power from the coil from the NQR detector system can be significantly lower than has been used in NQR landmine detection systems of the prior art. Due to this lower power the power supply and NQR sensor electronics can be made much smaller and more compact than has heretofore been the case, resulting in a lower cost, lower weight system that is truly man-portable. According to the invention, the small detector coil is carried at or near a distal end of a mine prodder so that it can be placed into contact with, or into the close vicinity of, the target to be sensed.

The mine prodder may, in some embodiments, be substantially rigid along at least a greater part, or all, of its length, or may have a rigidity which can be adapted with respect to time, and/or points along its length. For example, the coil may be carried on a controllable stiffness longitudinal member, such as a manipulator like the STIFF-FLOP manipulator, being developed under the EU funded STIFF-FLOP project, described at www.stiff-flop.eu.

More generally, whilst above and below we describe the use of a coil as the RF transducer for the sensor, in other embodiments other configurations may be used as RF antennae, for example a strip antenna having a flat piece of copper or PCB cut or bent into the appropriate shape and having its ends bridged with capacitors. Alternatively, the coil may be made from pipe rather than wire. Other arrangements of RF antenna that may be used in place of the described sensor coil will be apparent to the intended reader, it being understood that any suitable RF transducer such as an antenna of suitable size and frequency response may be used.

### Detailed Description of Embodiments

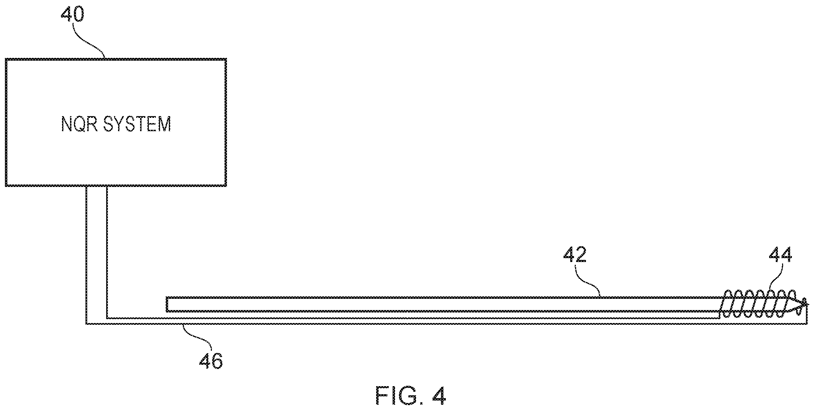

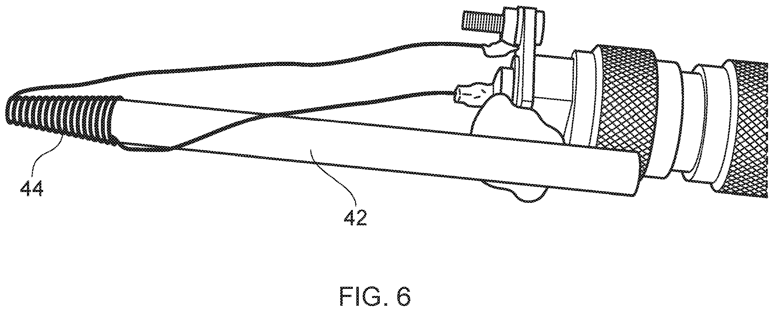

A first embodiment of the invention will now be described with respect to Figures 4, 5, and 6.

Figure 4 illustrates the basic arrangement of embodiments of the invention. Here an NQR system 40 is provided, that feeds NQR drive signals to antenna coil 44 mounted on the end of carrier 42, via wire connections 46. The carrier 42 is, for example, a conventional mine prodder stick, with coil 44 wound around the distal tip thereof. The arrangement and operation of the NQR system 40 is completely conventional, save for the fact that it may operate with lower power requirements, and generate signals of lower power, as will be described in further detail later. Otherwise, however, the system may be any known resonant or non-resonant NQR detection system for explosives, and hence in the interests of brevity, further details thereof will not be described. One example review of explosives detection with NQR systems was undertaken by Miller and Barrall, in American Scientist, Vol 93, pp.50-57.

With respect to the arrangement of the coil, a number of possible configurations are possible, mostly coils with both breadth and length that wrap around a bar or rod or hollow tube, which may have a circular cross-section, but not necessarily so; In addition "flat" coils e.g. a spiral that are attached to/embedded in the end of the bar or rod or tube may be used. The wires can run along inside the rod/bar/tube, or along the surface. The rod/bar/tube has to be non-conducting e.g. plastic. A thin jacket (<< 1 mm), also non-conducting, is preferably formed on the outside to protect the wires.

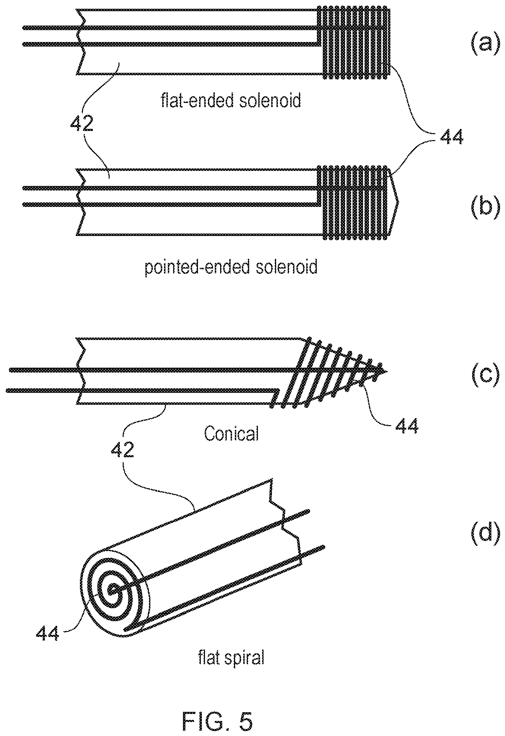

Figure 5 in (a) to (d) illustrates a number of the possible configurations. Here, the distal end 42 of the carrier (for example a prodder stick) is shown, bearing a coil 44. As shown in Figure 5(a), the coil may be wound around the distal end of the carrier to provide a flat ended solenoid arrangement, where the solenoid coil ends at the end of the carrier, and the carrier is substantially planar ended. Alternatively, the carrier may be slightly pointed, with the point being an obtuse angle, as shown in Figure 5(b), but here again the coil ends at the distal end, and does not extend over the pointed section.

Figure 5(c) shows a further example, where the point is an acute angle, and hence the end of the carrier is substantially conical or frusto-conical, or conical-like. In this example, due to the longer extension of the conical end of the carrier the coil winding can extend along the conical section towards the tip thereof at the distal end of the carrier.

Figure 5(d) shows an alternative example, where in this case instead of the coil being wrapped around the carrier such that it wraps around and extends along the longitudinal axis of the carrier, instead the coil is formed as a spiral on the distal end face of the carrier, the end face extending substantially normal to the longitudinal axis of the carrier, such that it itself faces substantially in the longitudinal direction. In this example, all of the coil is located at the same longitudinal position along the carrier (in this case at the end face), and hence in this configuration as much of the coil as possible is brought as close to the target (located in use next to or touching the end face) as possible.

In further embodiments combinations of the above arrangements may be possible. For example, the flat ended solenoid arrangement of Figures 5 (a) and (b) may be combined with the flat spiral end face arrangement of Figure 5 (d). Similarly, the conical spiral of Figure 5(c) may be combined with the solenoid coil arrangements of Figures 5(a) or (b), by having the coil extend further back along the carrier and hence being wound over the cylindrical part of the carrier as well as the conical part.

The principal physical dimension for such a coil to be useful for penetrating through a surrounding medium in order to be brought into contact with a target is the cross-sectional area (CSA). In terms of maximum diameter, for a circular CSA, around 20 mm is preferable. Most commercial mine prodders are 9 mm in diameter, and hence a range of, for example, 5 - 20 mm for the coil diameter is may be used successfully. With respect to the length of the coil (for the solenoid or conical arrangements), a length in the range of 9 - 25 mm is possible; the length should not be too long, as the coil volume should not be much bigger that the inspection volume, which is constrained by the CSA (i.e. the coil should not be much longer than it is broad). One example test coil used during development of embodiments of the invention is diameter = 15 mm, length = 25 mm, would as a substantially cylindrical coil; it could be shorter, but this coil works in terms of matching inductance/number of turns to desired frequency.

The number of turns of wire of the coil are decided by the desired frequency of operation - the lower the frequency, the more turns are desirable, within the constraints of the available space. Ideally as many turns as possible within the length and width constraints described above should be made appropriate to the inductance required to create a resonance at the frequency of interest.

With respect to the carrier 42, this can be as long as needed within the constraint that the receiver circuitry should be as close to the coil as possible to avoid unwanted signal loss in the wires. Carrier lengths in the ranges of 15cm to 50cm, or even as long as 1 m may be used. Other carrier lengths outside these ranges may also be used, depending on the application. With respect to carrier width, or cross-sectional area, this should be no greater than, and in embodiments where the coil is wrapped around the carrier, would be slightly less than, the diameter of the coil. Generally, the diameter of the carrier should be much less than its length. Diameters in the range of 4 to 19.5 mm may be typical, for coil diameters of 5 to 20mm as discussed above. The ratio of carrier length to carrier diameter may be in the range of 10:1, to as high as 200:1, or even 400:1 (for example for a 0.5cm diameter, with a 2m length).

Moreover, with respect to properties of the carrier itself, this may be rigid along its length, or may have one or more portions of reduced rigidity, to allow the carrier to be bent into any necessary shape in order to allow it to more easily penetrate the medium into which it is to be inserted to be brought into contact with the target. For example, the carrier may have rigid portions separated by bendable portions. The bendable portions may be sufficiently stiff such that when bent into position they stay where they are bent; that is, the bending force required to bend the portions into a desired position is typically greater than that which would be encountered in use. Alternatively, the carrier may be formed of a material and/or have a configuration that allows it to be bent at any point along its length, in order to allow the carrier to be bent into almost any desired shape. In this respect, the bendable properties of the carrier are such that it may be repeatedly bent from one shape to another, without overly weakening.

In addition, in another embodiment the carrier may be such that it is formed or configured such that the stiffness of the carrier can be varied with respect to time, preferably at any point along its length. This allows one or more portions of the carrier to be rendered less stiff when they are desired to be bent into shape, and then rendered more stiff when they are desired to be kept in a particular position or configuration (whether bent or stiff). One known technology that can provide modulating stiffness properties in the form of an elongated carrier is the STIFF-FLOP technology being developed as a carrier for medical devices, and described at www.stiff-flop.eu. In particular, this technology can be readily adapted to provide a bendable and stiffness controllable carrier upon which an NQR sensing coil can be mounted on the end as described above.

In terms of electromagnetic (EM) performance, peak power need be no more than 100 W (peak power) with such little coils, and they are ideally used at even low powers - for example, good results have been obtained at no more that 25 W (peak power). These powers compare well with known remote sensing coils which are required to work at kilowatts. Please note: this is peak power; the average power is around 10 to 20% of this value, as the RF is applied in pulses with gaps in between to capture the signals (e.g. pulse duration 200 microseconds, followed by 1000 microseconds of signal acquisition before the next pulse etc.). So a typical operating range in terms of power requirements is of the order of 100 mW - 100 W (peak power). In terms of RF field strength, the range is around 100 microTesla to around 1 milliTesla at target as desirable/achievable at these power levels with these size coils.

More generally, the operating principle behind the small coil is that the reduced distance to target when in use is used to compensate for the sub-optimal impedance mismatch between the target and the small coil. Generally in NQR systems the NQR coil is usually the same size as the target object; for example in an airport bag scanner the NQR coil would generally be the same size as a typical bag or suitcase being scanned. This is so the whole target is effectively energised by the coil, and resulting NQR signals can be obtained from anywhere in the target.

In the present arrangement the small coil is usually much smaller than the target (typically a landmine), and hence there is sub-optimal mutual inductance between the target and the coil with the result that only a portion of the target is energised and thus returns an NQR signal. However, in the context of landmine clearance this is not important, as the operating modality of bringing the coil into contact with the target effectively locates the target, and then all that is being required of the NQR system is to confirm that explosive material is present. Even though only a portion of the target is thus "scanned" by the coil for explosives, any such explosives in a landmine will be detected, and hence the discrimination between landmine and other objects (e.g. buried rock or stone) is then complete. That is, in order to determine that an object is a landmine that should be cleared, it is not necessary to confirm that there is explosives throughout the body of the object; it is instead sufficient to confirm that explosives are present in the smaller volume which can be effectively energised by the small coil mounted on the tip of the carrier.

### QR Measurements

As proof of concept we have constructed a prodder coil sensor according to embodiments of the invention as described above, and a typical conventional remote sensor coil to allow for direct comparison of performance. For ease of operation we first opted for ³⁵Cl QR at 34 MHz. This made it easier to bring the simple prodder sensor employed here to resonance than working at ¹⁴N frequencies (< 5.5 MHz), but all conclusions regarding RF power/field and signal return would apply equally well at nitrogen frequencies. And subsequent to these early measurements a coil for operating at 14N frequencies was constructed and successfully tested, as described below.

The prodder sensor was a simple solenoid mounted on the end of a 15 mm diameter plastic rod. The comparison remote sensor was a simple two-turn loop wrapped around a 100 mm diameter plastic tube. These dimensions were chosen as they correspond to the target form factors and distances to target ("burial depths") that would be encountered in humanitarian demining. The sample (1,4-dichlorobenzene) quantity was set to 70 grams for the same reason. Typical characteristics of target mines that were used in the Balkans during the 1990s (and which are still the subject of mine clearance operations) are shown in the table below.

| Typical Characteristics of Plastic-Cased Anti-personnel Mines encountered in Croatia | |
|---|---|
| Explosive content | 35 - 200 grams of TNT (PMA-3 - PMA-1) |
| Burial depth (with settling) | 50 - 150 mm^{a} |

| | |
|---|---|
| ^{a} generally buried up to a depth of 90 - 100 mm from surface to top of mine, but can settle deeper over time | |

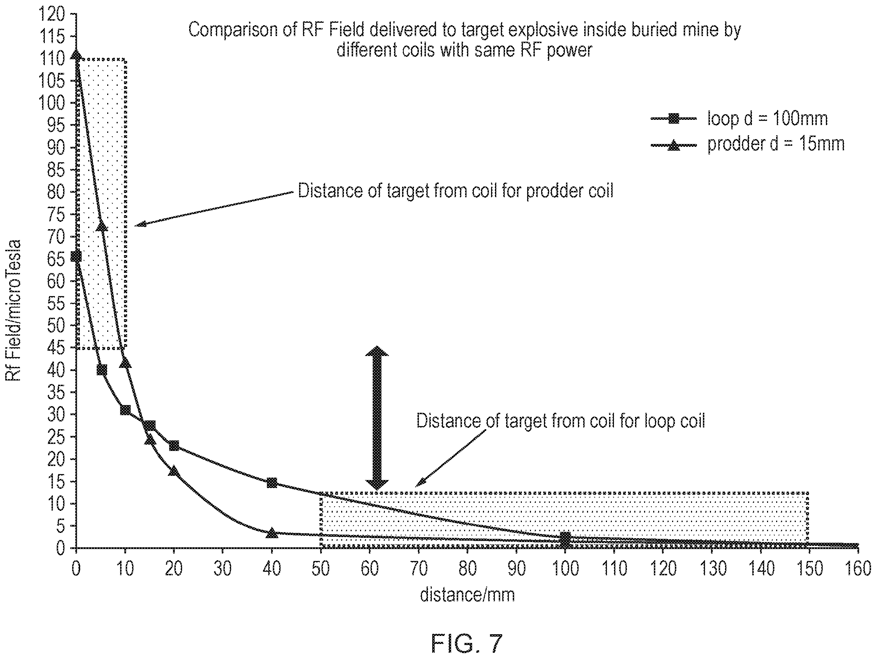

First we measured the RF field generated by the two sensors at different distances from their "faces" for the same RF power supplied. Figure 7 illustrates the results, from which it can be seen that the RF field delivered to the target by the prodder coil of the embodiments was greater than that delivered by the comparison loop coil, particularly at short distances (<10mm) from the target. Above 10mm the RF field drops off more quickly than the conventional loop coil, but given that the operational modality of embodiments of the present invention is to bring the coil into contact with the target, this is of less concern.

As a consequence, the dual advantages of the prodder - it is a small coil that is designed to operate in contact with the target - result in a greatly enhanced performance compared to the remote sensor ("loop"). In order to deliver the same RF field to the target, much, much more power (at least 16x) would need to be supplied to the remote sensor compared to that supplied to the prodder sensor. In fact, the equipment we had available would not be able to provide the amount of power required. Note: some of these field differences can be compensated for by applying the RF pulses for longer, but there is a limit to which this approach can be employed due to average power limits and RF bandwidth requirements (long pulses = narrow bandwidths - too narrow to capture the signal). A 16x difference in power requirement cannot therefore be overcome in this way.

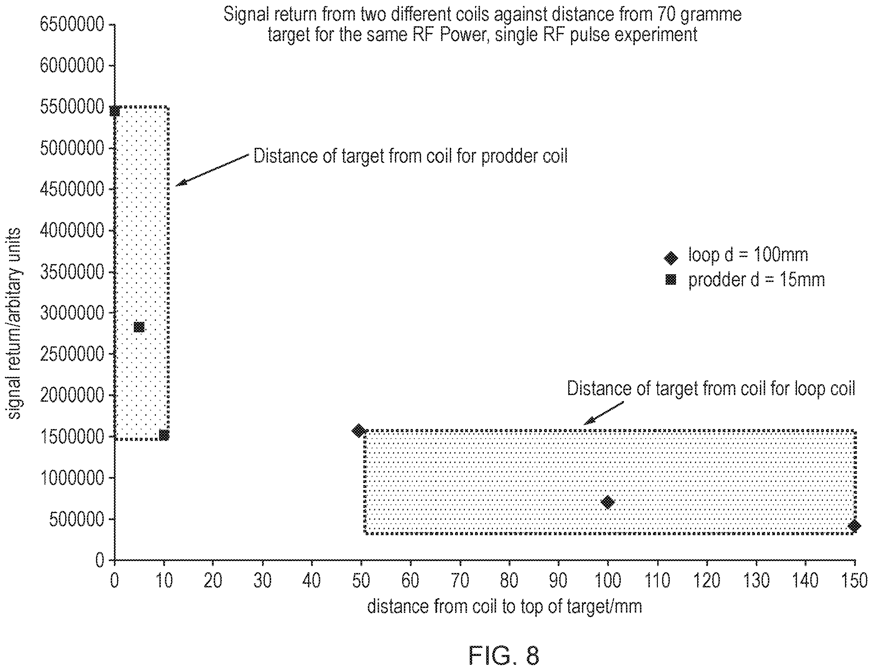

If we turn now to the signals returned by the 70-gramme sample placed at different distances from the sensors (representing different burial depths), there is, at least in the initial experiment, some more positive news for the remote sensor, as the differences are much less pronounced. Figure 8 shows these results.

In Figure 8 we see the effect of the advantage of the larger remote sensor interacting with more of the sample than the smaller prodder - the signal returned from each unit mass of sample is smaller, but the total mass returning signal is greater. It follows that, if the sample used were larger, the difference in signal returned would be even smaller, and, for large sample masses, would disappear altogether. However, this is for the so-called "single pulse experiment", where signal is returned at whatever RF field is experienced by the target (it is just weaker for smaller fields). The problem with the single pulse experiment is that the signal it returns is indistinguishable from certain types of radiofrequency interference - not a problem in the laboratory when an RF shield can be employed, but a considerable problem in the field, when no such shielding is possible. In the field a different type of RF pulse experiment must be used to generate a signal whose characteristics (time signature) are distinct enough from radiofrequency interference to allow the two to be distinguished from one another. These are experiments of the so-called "echo type" that employ multiple pulses. However, the ability of such sequences to generate these distinctive signals is heavily RF field dependent - below a certain RF field (for a given pulsed duration) these signals are not generated.

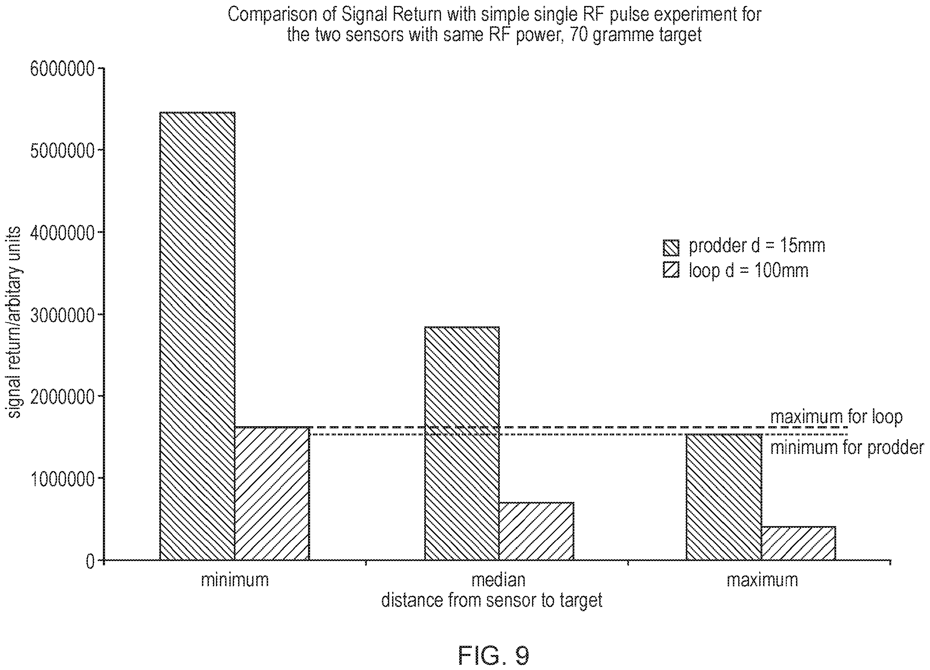

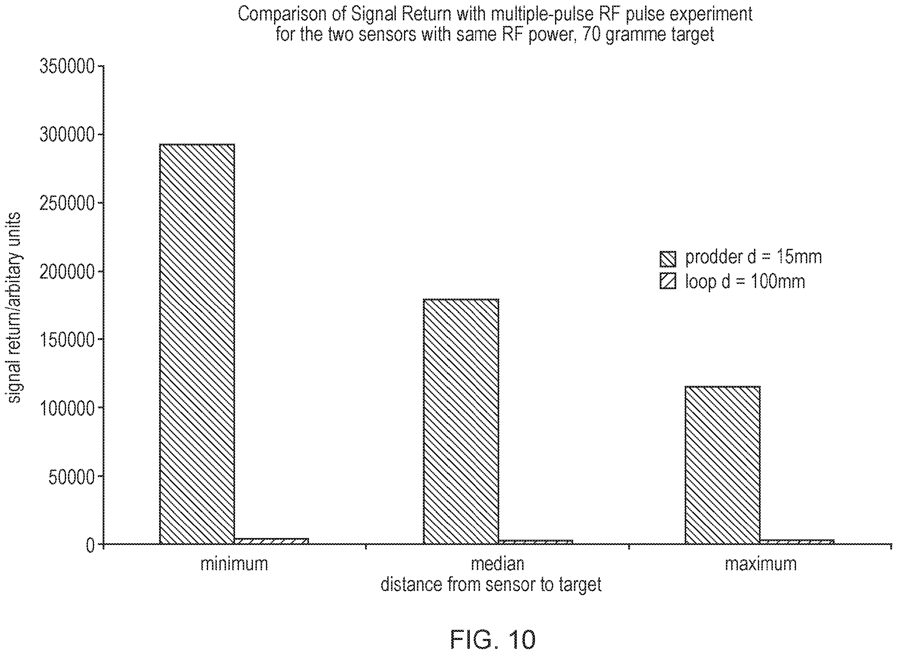

So if we turn now to a comparison of the signal returned by the single-pulse versus the echo type of sequence shown in Figures 9 and 10, we see that the coil size advantage of the large loop is wiped out by the difficultly of supplying sufficient RF power to the sample - of whatever size - at depth. At this RF power, the loop simply cannot generate a large-enough RF field at the target to generate an echo signal. Moving to a larger sample would help, but only to a small degree, and only at the shortest separation between coil and target as it is the RF field at target that is key.

| Distance from sensor to top of target for different modes of operation/mm | | |
|---|---|---|
| | Prodder d = 15 mm | Remote Sensor (Loop) d = 100 mm |
| Minimum | 0 | 50 |
| Median | 5 | 100 |
| Maximum | 10 | 150 |

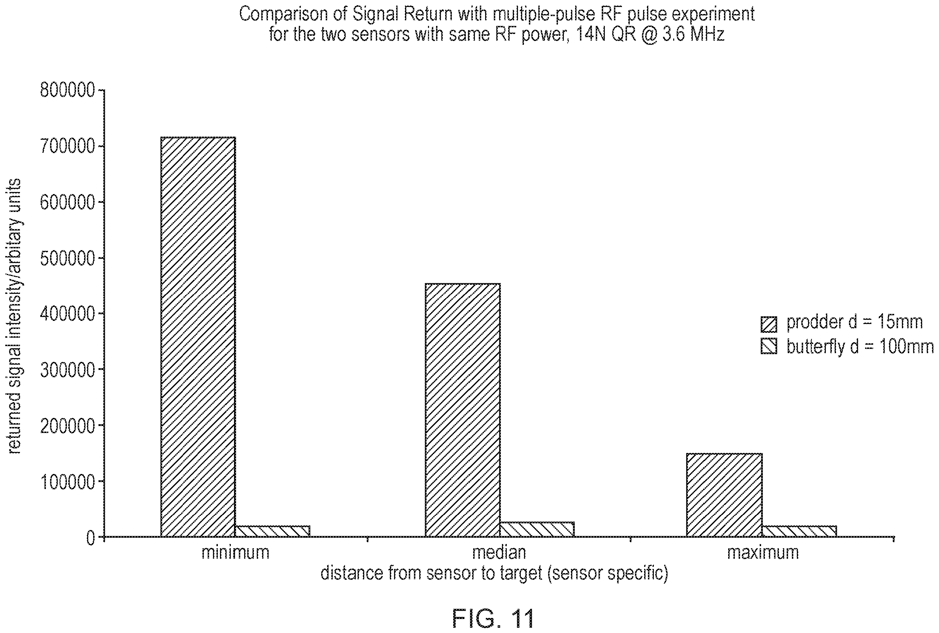

In addition, it is also possible to construct a prodder-like coil such as those described above that can be used as part of a resonant circuit at Nitrogen-14 frequencies (0 - 5.5 MHz) - the target for explosives detection. Repeating the last of the tests above, using multiple-pulse pulse sequences, such a prodder coil versus a unilateral spiral-like coil with a 120 g sample of NaNO2 (14N QR frequency 3.603 MHz), gives a result in Figure 11 which is substantially the same as shown in Figure 10, validating the argument.

Various further modifications, whether by way of addition, deletion, or substitution may be made to the above mentioned embodiments to provide further embodiments falling within the scope of the invention as defined by the appended claims.

## Claims

1. An explosives detection system, comprising:
a nuclear quadrupole resonance (NQR) detector system (40) having an NQR antenna (44); and
a mine prodder (42),
the arrangement being such that the NQR antenna (44) is carried at or near a distal end of the mine prodder (42), the arrangement of the NQR antenna (44) and mine prodder (42) being such that in use the mine prodder (42) is able to carry the NQR antenna (44) so that the NQR antenna (44) and mine prodder (42) are able to penetrate through a soil-like medium when in use so as to be brought into contact with a buried object in an orientation such that the NQR antenna (44) is brought into contact with or into the near vicinity of the buried object.

2. A system according to claim 1, wherein the mine prodder is substantially rigid along at least a greater part, or all, of its length.

3. A system according to any of the preceding claims, wherein the mine prodder has one or more portions along its length of reduced rigidity to allow the prodder to be bent into a desired shape.

4. A system according to any of the preceding claims, wherein the mine prodder has one or more portions along its length of adaptable rigidity, to allow the prodder to be bent into a desired shape.

5. A system according to any of the preceding claims, wherein the NQR antenna is a sensor coil.

6. A system according to claim 5, wherein the coil diameter is in the range of 5mm to 25mm, and more preferably 10 to 20mm.

7. A system according to any of claims 5 or 6, wherein the coil length is in the range of 5mm to 30mm, and more preferably in the range of 9mm to 25mm.

8. A system according to any of the preceding claims, wherein the system is configured such that in use the NQR antenna generates a RF field strength in the range of 100 microTesla to 1 milliTesla.

9. A system according to any of the preceding claims, wherein the system is configured such that in use the NQR antenna operates at a peak power of 100mW to 100W.

10. A system according to claim 9, wherein the system is configured such that in use the NQR antenna operates at a peak power of no more than 25W.

11. A method of target material discrimination, comprising:
providing a system according to any of the preceding claims;
inserting the mine prodder (42) carrying the NQR antenna (44) at its tip into the ground towards a target so as to bring the NQR antenna (44) into contact with or the near vicinity of the target; and
activating the NQR detection system (40) to undertake NQR based target material discrimination.

## Patentansprüche

1. Sprengstoffdetektionssystem, umfassend
ein Kernquadrupolresonanz (NQR)-Detektorsystem (40) mit einer NQR-Antenne (44); und
eine Minensonde (42),
die Anordnung ist derart, dass die NQR-Antenne (44) an oder nahe einem distalen Ende der Minensonde (42) getragen wird, die Anordnung der NQR-Antenne (44) und der Minensonde (42) ist derart, dass die Minensonde (42) im Gebrauch in der Lage ist, die NQR-Antenne (44) zu tragen, so dass die NQR-Antenne (44) und die Minensonde (42) im Gebrauch in der Lage sind, durch ein bodenartiges Medium zu dringen, um mit einem vergrabenen Objekt in einer solchen Ausrichtung in Kontakt gebracht zu werden, dass die NQR-Antenne (44) mit dem vergrabenen Objekt in Kontakt oder in die unmittelbare Nähe des vergrabenen Objekts gebracht wird.

2. System gemäß Anspruch 1, wobei die Minensonde zumindest entlang eines größeren Teils oder ihrer gesamten Länge im Wesentlichen steif ist.

3. System gemäß einem der vorhergehenden Ansprüche, wobei die Minensonde einen oder mehrere Abschnitte entlang ihrer Länge mit verringerter Steifigkeit aufweist, damit die Sonde in eine gewünschte Form gebogen werden kann.

4. System gemäß einem der vorhergehenden Ansprüche, wobei die Minensonde einen oder mehrere Abschnitte entlang ihrer Länge mit anpassbarer Steifigkeit aufweist, damit die Sonde in eine gewünschte Form gebogen werden kann.

5. System gemäß einem der vorhergehenden Ansprüche, wobei die NQR-Antenne eine Sensorspule ist.

6. System gemäß Anspruch 5, wobei der Spulendurchmesser im Bereich von 5 mm bis 25 mm und besonders bevorzugt 10 bis 20 mm liegt.

7. System gemäß einem der Ansprüche 5 oder 6, wobei die Spulenlänge im Bereich von 5 mm bis 30 mm und besonders bevorzugt im Bereich von 9 mm bis 25 mm liegt.

8. System gemäß einem der vorhergehenden Ansprüche, wobei das System derart konfiguriert ist, dass die NQR-Antenne im Gebrauch eine RF-Feldstärke im Bereich von 100 microTesla bis 1 milliTesla erzeugt.

9. System gemäß einem der vorhergehenden Ansprüche, wobei das System derart konfiguriert ist, dass die NQR-Antenne im Gebrauch mit einer Spitzenleistung von 100 mW bis 100 W arbeitet.

10. System gemäß Anspruch 9, wobei das System derart konfiguriert ist, dass die NQR-Antenne im Gebrauch mit einer Spitzenleistung von nicht mehr als 25 W arbeitet.

11. Verfahren zur Zielmaterialunterscheidung, umfassend:
Bereitstellen eines Systems gemäß einem der vorhergehenden Ansprüche;
Einführen der Minensonde (42), welche die NQR-Antenne (44) an ihrer Spitze trägt, in den Boden in Richtung eines Ziels, um die NQR-Antenne (44) in Kontakt mit dem Ziel oder in die unmittelbare Nähe des Ziels zu bringen; und
Aktivieren des NQR-Detektionssystems (40), um eine NQR-basierte Zielmaterialunterscheidung durchzuführen.

## Revendications

1. Système de détection d'explosifs, comprenant :
un système de détection à résonance quadripolaire nucléaire (NQR) (40) qui possède une antenne NQR (44) ; et
une sonde de déminage (42),
l'ensemble étant tel que l'antenne NQR (44) est portée au niveau ou à proximité d'une extrémité distale de la sonde de déminage (42), l'ensemble de l'antenne NQR (44) et de la sonde de déminage (42) étant tel que, pendant l'utilisation, la sonde de déminage (42) est capable de porter l'antenne NQR (44) de sorte que l'antenne NQR (44) et la sonde de déminage (42) puissent pénétrer à travers un milieu qui s'apparente à de la terre pendant l'utilisation, de façon à être amenées en contact avec un objet enfoui dans une orientation telle que l'antenne NQR (44) est amenée en contact avec ou à proximité de l'objet enfoui.

2. Système selon la revendication 1, dans lequel la sonde de déminage est sensiblement rigide le long d'au moins une grande partie, ou la totalité, de sa longueur.

3. Système selon l'une quelconque des revendications précédentes, dans lequel la sonde de déminage possède une ou plusieurs partie(s), le long de sa longueur, qui présente(nt) une rigidité réduite afin de permettre à la sonde de déminage d'être courbée en une forme souhaitée.

4. Système selon l'une quelconque des revendications précédentes, dans lequel la sonde de déminage possède une ou plusieurs partie(s) le long de sa longueur qui présente(nt) une rigidité adaptable, afin de permettre à la sonde d'être courbée dans une forme souhaitée.

5. Système selon l'une quelconque des revendications précédentes, dans lequel l'antenne NQR est une bobine de capteur.

6. Système selon la revendication 5, dans lequel le diamètre de la bobine est compris entre 5 mm et 25 mm, et de préférence entre 10 et 20 mm.

7. Système selon l'une quelconque des revendications 5 ou 6, dans lequel la longueur de la bobine est comprise entre 5 mm et 30 mm, et de préférence entre 9 mm et 25 mm.

8. Système selon l'une quelconque des revendications précédentes, dans lequel le système est configuré de sorte que, pendant l'utilisation, l'antenne NQR génère une intensité de champ RF comprise entre 100 microtesla et 1 millitesla.

9. Système selon l'une quelconque des revendications précédentes, dans lequel le système est configuré de sorte que, pendant l'utilisation, l'antenne NQR fonctionne à une puissance maximale comprise entre 100 mW et 100 W.

10. Système selon la revendication 9, dans lequel le système est configuré de sorte que, pendant l'utilisation, l'antenne NQR fonctionne à une puissance maximale non supérieure à 25 W.

11. Procédé de différentiation de matériau cible, comprenant :
le fait de prévoir un système selon l'une quelconque des revendications précédentes ;
l'insertion de la sonde de déminage (42) qui porte l'antenne NQR (44) en son extrémité dans le sol, vers une cible, de façon à amener l'antenne NQR (44) en contact avec ou à proximité de la cible ; et
l'activation du système de détection NQR (40) afin d'effectuer une différentiation de matériau cible sur la base d'une NQR.
